# EUROPÄISCHE PATENTSCHRIFT

(11) **EP 0 561 316 B1**
(45) Veröffentlichungstag und Bekanntmachung des Hinweises auf die Patenterteilung: **17.04.1996**
(21) Anmeldenummer: 93104139.6
(22) Anmeldetag: 13.03.1993
(51) Int. Cl.: H03K 17/691, H03K 17/04, H03K 17/56

(54) **Schaltung zur Ansteuerung eines spannungsgesteuerten Halbleiterschalters**
Driving circuit for a voltage-controlled semi-conducteur switch
Circuit de commande pour un commutateur semi-conducteur commandé en tension

(30) Priorität: 19.03.1992 DE 4208894
(43) Veröffentlichungstag der Anmeldung: 22.09.1993
(73) Patentinhaber: ABB PATENT GmbH, D-68309 Mannheim (DE)
(72) Erfinder: Löffler, Dieter, W-6930 Eberbach (DE)
(74) Vertreter: Rupprecht, Klaus, Dipl.-Ing.

(56) Entgegenhaltungen:
- US-A- 4 970 420
- IEEE CONFERENCE RECORD OF THE 1988 EIGHTEENTH POWER MODULATOR SYMPOSIUM 1988, NEW YORK US Seiten 28 - 33 WALTER F. J. CREWSON ET AL. 'Solid-State 2kV, 250 KHz Grid Modulator for Traveling-Wave Tubes'
- CONFERENCE RECORD OF THE 1990 IEEE INDRUSTRY APPLICATIONS SOCIETY ANNUAL MEETING PART II Oktober 1990, NEW YORK US Seiten 1049 - 1055 YOUICHI ITOH 'High Performance and Long Life Uninterruptible Power Source Using a Flywheel Energy Storage Unit'
- PATENT ABSTRACTS OF JAPAN vol. 10, no. 279 (E-439)(2335) 20. September 1986

## Beschreibung

Die Erfindung bezieht sich auf eine Schaltung zur Ansteuerung eines spannungsgesteuerten Halbleiterschalters gemäß dem Oberbegriff des Anspruchs 1.

Eine derartige Schaltung ist aus US-A-4 970 420 bekannt.

Die Schaltung kann bei allen Arten von Halbleiterschaltern, insbesondere Leistungsschaltern, eingesetzt werden, die leistungslos mit einem elektrischen Feld gesteuert werden und bei denen ein passives Ausschalten aus Gründen der Dynamik nicht ausreicht, beispielsweise bei MOSFET (Metal-Oxide semiconductor-Feldeffekttransistor) und IGBT (Insulated-Gate Bipolar Transistor). Mögliche Anwendungen sind z.B. Überbrücken eines Anlaufwiderstandes oder Schalten eines Bremswiderstandes.

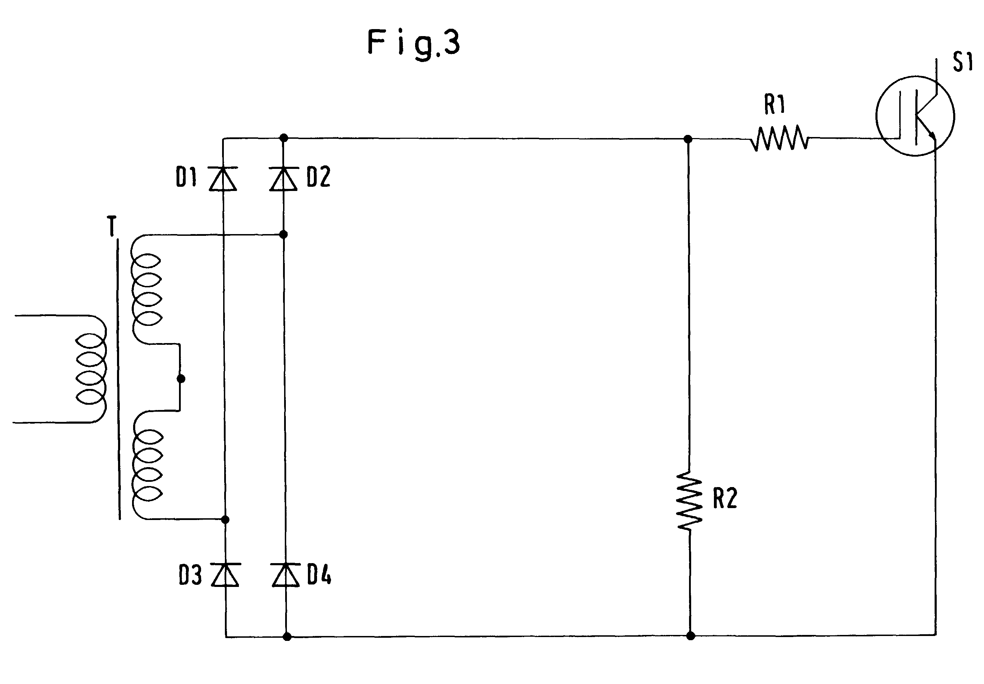

In Figur 3 ist eine einfache Schaltung zur Ansteuerung eines spannungsgesteuerten Halbleiterschalters S1 dargestellt. Es ist ein Übertrager T zu erkennen, dessen Primärwicklung mit der Ansteuerspannung für den Schalter S1 beaufschlagt wird. Der Schalter S1 wird eingeschaltet und verbleibt im leitenden Zustand, so lange die Ansteuerspannung an der Primärwicklung ansteht. Durch Abschaltung der Ansteuerspannung an der Primärwicklung wird der Schalter S1 nach einer gewissen Verzögerungszeit gesperrt und verbleibt im sperrenden Zustand. Der Übertrager T weist eine Sekundärwicklung auf, deren Klemmen mit den Wechselspannungsanschlüssen eines Brückengleichrichters D1/D2/D3/D4 verbunden sind. Der positive Gleichspannngsanschluß des Brückengleichrichters führt über einen niederohmigen Vorwiderstand R1 (Gatewiderstand) zum Gate des Schalters S1. Der negative Gleichspannungsanschluß des Brückengleichrichters ist mit dem Emitter bzw. Source des Schalters S1 verbunden, je nachdem, ob es sich beim Schalter S1 um einen IGBT oder um einen MOSFET handelt. Positiver und negativer Gleichspannungsanschluß des Brückengleichrichters sind über einen Widerstand R2 miteinander verbunden.

Wie bereits erwähnt, wird der Schalter S1 durch eine mit dem Übertrager T eingekoppelte Spannung eingeschaltet. Die Eingangskapazität zwischen Gate und Source bzw. zwischen Gate und Emitter des Schalters S1 wird beim Einschalten aufgeladen. Die Abschaltung des Schalters S1 erfolgt passiv durch Entladen der Eingangskapazität über die Widerstände R1 und R2, nachdem die Ansteuerspannung am Übertrager T auf Nullpotential abgefallen ist. Bei der Abschaltung des Schalters S1 sind dabei zwei widerstrebende Forderungen zu beachten. Der ohmsche Wert des Widerstandes R2 darf einerseits nicht zu klein sein, damit der während des Einschaltzustandes des Schalters S1 über die Gleichspannungsanschlüsse des Brückengleichrichters fließende Gleichstrom nicht zu hoch wird. Ein zu hoher Gleichstrom belastet insbesondere die Steuerspannungsquelle zur Abgabe der Ansteuerspannung zu stark (relativ hohe Verlustleistung). Andererseits ist ein schnelles Abschalten des Schalters S1 erwünscht und hierzu sollte der Widerstand R2 möglichst klein sein, damit sich die Eingangskapazität des Schalters S1 schnell entladen kann.

Der Erfindung liegt die Aufgabe zugrunde, eine Schaltung zur Ansteuerung eines spannungsgesteuerten Halbleiterschalters der eingangs genannten Art anzugeben, die einerseits die Steuerspannungsquelle nicht stark belastet und andererseits den Schalter rasch abschaltet.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß die vorgeschlagene Schaltung sehr preiswert ist und nur einen geringen Aufwand erfordert. Die zusätzlich benötigten Dioden sind billige Signaldioden, der zusätzliche Schalter ist ein billiger Kleinsignaltransistor (beispielsweise ein Kleinsignal-IGBT). Die Schaltung erfordert vorteilhaft weder einen zweiten Übertrager, noch eine aufwendige, aus positiven und negativen Ansteuerpulsen aufgebaute Ansteuerspannung. Ferner ist keine zusätzliche Zufuhr von Hilfsenergie notwendig. Die Verlustleistung der Schaltung ist relativ gering.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:
- Figur 1: eine Schaltung zur Ansteuerung eines IGBT,
- Figur 2: eine Schaltung zur Ansteuerung eines MOSFET.

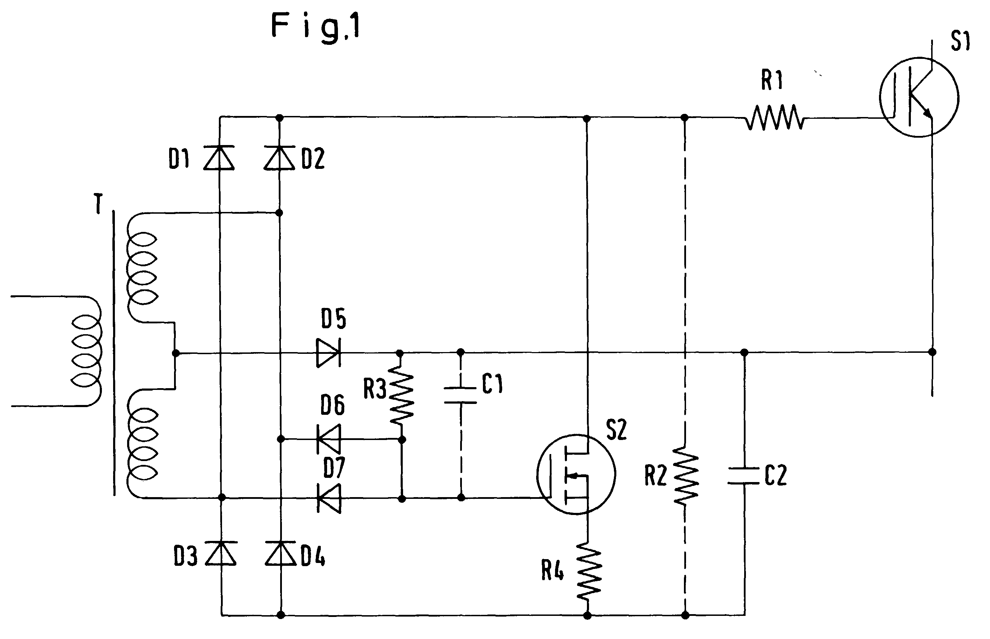

In Figur 1 ist eine Schaltung zur Ansteuerung eines IGBT dargestellt. Es ist zu erkennen, daß der Übertrager T eine Sekundärwicklung mit Mittenanzapfung aufweist, wobei die äußeren Klemmen der Sekundärwicklungshälften mit dem Brückengleichrichter D1/D2/D3/D4 verbunden sind und die Mittenanzapfungsklemme über eine Diode D5 an die erste Klemme eines hochohmigen Widerstandes R3, an die erste Klemme eines Stützkondensators C2 und an den Emitter des Schalters S1, d.h. des IGBT angeschlossen ist. Dabei liegt die Anode der Diode D5 an der Mittenanzapfung. Die Primärwicklung des Übertragers T ist wiederum mit einer Steuerspannungsquelle verbunden, die die Ansteuerspannung zum Ein/Aus-Schalten des Schalters S1 abgibt.

Die zweite Klemme des Widerstandes R3 ist über zwei Dioden D6, D7 mit den äußeren Klemmen der Sekundärwicklungshälften verbunden, wobei die Anoden der Dioden D6, D7 am Widerstand R3 liegen. Die zweite Klemme des Kondensators C2 ist mit dem negativen Gleichspannungsanschluß des Brückengleichrichters verbunden.

Das Gate des Schalters S1 liegt wiederum über dem Gatewiderstand R1 am positiven Gleichspannungsanschluß des Brükkengleichrichters. Ebenfalls mit dem positiven Gleichspannungsanschluß ist der Kollektor oder Drain eines Hilfsschalters S2 verbunden. Der Emitter oder Source dieses Schalters S2 liegt über einem niederohmigen Entladewiderstand R4 am negativen Gleichspannungsanschluß des Brückengleichrichters. Das Gate des Schalters S2 ist an den Verbindungspunkt von R3/D6/D7 angeschlossen. Als Hilfsschalter S2 kann ein MOSFET oder ein Kleinsignal-IGBT verwendet werden.

Dem Widerstand R3 kann ein Stützkondensator C1 zur Spannungsstabilisierung parallelgeschaltet sein.

Zwischen den Gleichspannungsanschlüssen des Brückengleichrichters kann der hochohmige Widerstand R2 zur Bezugspunktbildung geschaltet sein.

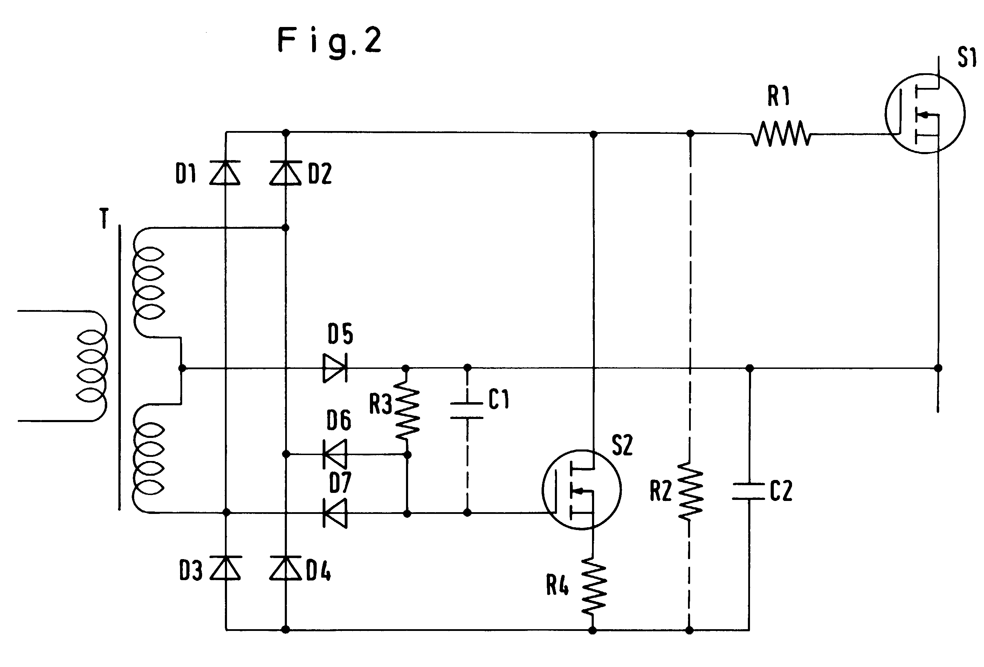

In Figur 2 ist eine Schaltung zur Ansteuerung eines MOSFET dargestellt. Diese Schaltung entspricht der Schaltung gemäß Figur 1 mit dem Unterschied, daß ein MOSFET anstelle eines IGBT als Schalter S1 Verwendung findet.

Nachfolgend wird die Funktionsweise der Schaltungen gemäß Figuren 2 und 3 beschrieben. Zum Einschalten des Schalters S1 wird eine Wechselspannung an die Primärwicklung des Übertragers T angelegt (Ansteuerspannung). Vorzugsweise wird eine hochfrequente Burstspannung verwendet. Die in der Sekundärwicklung des Übertragers induzierte Wechselspannung wird über den Brückengleichrichter D1/D2/D3/D4 gleichgerichtet, so daß an den Kathoden der Dioden D1, D2 eine positive und an den Anoden der Dioden D3, D4 eine negative Spannung ansteht. Die positive Spannung lädt die Eingangskapazität des Schalters S1 über den niederohmigen Widerstand R1 relativ rasch auf, so daß die Kollektor-Emitter-Strecke bzw. Drain-Source-Strecke des Schalters S1 durchschaltet.

An den Anoden der Dioden D6, D7 steht eine negative Spannung an. Da diese negative Spannung das Gate des Hilfsschalters S2 beaufschlagt, bleibt die Kollektor-Emitter-Strecke bzw. Drain-Source-Strecke des Hilfsschalters S2 gesperrt. Der über die Mittenanzapfung der Sekundärwicklung des Übertragers T, die Diode D5, den Widerstand R3, die Dioden D6, D7 und die Sekundärwicklungshälften fließende Strom ist relativ gering, da - wie bereits ausgeführt - der Widerstand R3 hochohmig ist. Desgleichen ist der Stromfluß über die Dioden D1, D2, D3, D4, dem bedarfsweise einsetzbaren Widerstand R2 und die Sekundärwicklungshälften aufgrund der Hochohmigkeit des Widerstandes R2 relativ gering. Der Kondensator C2 wird auf eine bezüglich der Spannung der Eingangskapazität des Schalters S1 negative Spannung aufgeladen.

Zum Ausschalten des Schalters S1 wird die an der Primärwicklung des Übertragers T anstehende Wechselspannung abgeschaltet. Folglich sperren die Dioden D6, D7 und das Gate des Hilfsschalters S2 wird nach einer kurzen, durch den Kondensator C1 bedingten Zeitkonstante über den Widerstand R3 mit einer im Vergleich zur Spannung am Emitter bzw. Source des Hilfsschalters S2 positiven Spannung beaufschlagt. Die Zeitkonstante entfällt, falls der Kondensator C1 nicht eingesetzt wird. Nachfolgend schaltet die Kollektor-Emitter-Strecke bzw. Drain-Source-Strecke des Hilfsschalters S2 durch und die Eingangskapazität zwischen Gate und Source bzw. Emitter des Schalters S1 wird über den niederohmigen Widerstand R1, die Kollektor-Emitter-Strecke bzw. Drain-Source-Strecke des Schalters S2 und den niederohmigen Widerstand R4 mit dem negativen Potential des Kondensators C2 verbunden, was zur raschen Entladung der Eingangskapazität des Schalters S1 und damit zum Sperren der Kollektor-Emitter-Strecke bzw. Drain-Source-Strecke des Schalters S1 führt (siehe Stromkreis über die Emitter-Gate-Strecke bzw. Source-Gate-Strecke des Schalters S1, den Widerstand R1, die Kollektor-Emitter-Strecke bzw. Drain-Source-Strecke des Hilfsschalters S2, den Widerstand R4 und den Kondensator C2). Der Kondensator C2 stellt damit sicher, daß auch nach dem Abschalten der Wechselspannung am Übertrager (Ansteuerspannung) noch eine negative Spannung zum raschen Sperren des Schalters S1 zur Verfügung steht. Hierdurch wird der Ausschaltvorgang von S1 wesentlich beschleunigt. Aufgrund der sperrenden Diode D5 wird eine Entladung des Kondensators C2 verhindert.

## Patentansprüche

1. Schaltung zur Ansteuerung eines spannungsgesteuerten Halbleiterschalters mit einem Halbleiterschalter (S1), dessen Gate über einen Gatewiderstand (R1) mit dem positiven Gleichspannungsanschluß eines Brückengleichrichters (D1-D4) verbunden ist, der an die Sekundärwicklung eines Übertragers (T) angeschlossen ist, an dessen Primärwicklung eine zur Ansteuerung des Schalters dienenden Spannung ansteht,
- wobei eine Reihenschaltung der Kollektor-Emitter-Strecke bzw. Drain-Source-Strecke eines Hilfsschalters (S2) und eines zweiten Widerstandes (R4) zwischen den Gleichspannungsanschlüssen des Brückengleichrichters angeordnet ist,
- wobei die Sekundärwicklung des Übertragers (T) eine Mittenanzapfung aufweist, die mit dem Emitter oder Source des Halbleiterschalters (S1), einem ersten Kondensator (C2) und einem dritten Widerstand (R3) verbunden ist,
- und wobei der erste Kondensator (C2) einerseits am negativen Gleichspannungsanschluß des Brückengleichrichters (D1/D2/D3/D4) liegt,
dadurch gekennzeichnet
- daß der dritte Widerstand (R3) andererseits an die Anoden von zwei mit ihren Kathoden mit den äußeren Klemmen der Sekundärwicklungshälften des Übertragers (T) verbundenen Dioden (D6,D7) und an das Gate des Hilfsschalters (S2) angeschlossen ist.

2. Schaltung nach Anspruch 1, dadurch gekennzeichnet, daß eine Diode (D5) zwischen der Mittenanzapfung und dem zweiten Kondensator (C2) liegt, deren Kathode mit dem ersten Kondensator verbunden ist.

3. Schaltung nach Anspruch 1 und/oder 2, dadurch gekennzeichnet, daß dem dritten Widerstand (R3) ein zweiter Kondensator (C1) parallelgeschaltet ist.

4. Schaltung nach wenigstens einem der Ansprüche 1 bis 3, dadurch gekennzeichnet, daß ein vierter Widerstand (R2) zwischen den Gleichspannungsanschlüssen des Brückengleichrichters (D1/D2/D3/D4) liegt.

## Claims

1. Circuit for driving a voltage-controlled semiconductor switch with a semiconductor switch (ST), the gate of which is connected via a gate resistor (R1) to the positive direct-voltage terminal of a bridge rectifier (D1-D4) which is connected to the secondary winding of a transformer (T), across the primary winding of which a voltage used for driving the switch is present,
- a series circuit of the collector-emitter path or drain-source path of an auxiliary switch (S2) and of a second resistor (R4) being arranged between the direct-voltage terminals of the bridge rectifier,
- the secondary winding of the transformer (T) having a centre tap which is connected to the emitter or source of the semiconductor switch (S1), a first capacitor (C2) and a third resistor (R3),
- and the first capacitor (C2) being connected at one end to the negative direct-voltage terminal of the bridge rectifier (D1/D2/D3/D4),
characterised in that
- the third resistor (R3) is connected at the other end to the anodes of two diodes (D6, D7), connected by their cathodes to the outer terminals of the secondary winding halves of the transformer (T), and to the gate of the auxiliary switch (S2).

2. Circuit according to Claim 1, characterised in that a diode (D5) is connected between the centre tap and the second capacitor (C2), the cathode of which is connected to the first capacitor.

3. Circuit according to Claim 1 and/or 2, characterised in that a second capacitor (C1) is connected in parallel with the third resistor (R3).

4. Circuit according to at least one of Claims 1 to 3, characterised in that a fourth resistor (R2) is connected between the direct-voltage terminals of the bridge rectifier (D1/D2/D3/D4).

## Revendications

1. Circuit destiné à la commande d'un commutateur à semiconducteurs commandé en tension, avec un commutateur à semiconducteur (S1) dont la grille est connectée par l'intermédiaire d'une résistance (R1) de grille à la borne de tension continue positive d'un redresseur (D1-D4) en pont qui est connecté à l'enroulement secondaire d'un transformateur (T) dont l'enroulement primaire duquel reçoit une tension servant à la commande du commutateur,
- un circuit série formé de la jonction collecteur-émetteur ou de la jonction drain-source d'un commutateur (S2) auxiliaire et d'une deuxième résistance (R4) étant placé entre les bornes de tension continue du redresseur en pont,
- l'enroulement secondaire du transformateur (T) comportant une prise de milieu qui est connectée à l'émetteur ou à la source du commutateur à semiconducteur (S1), à un premier condensateur (C2) et à une troisième résistance (R3),
- le premier condensateur (C2) étant connecté d'un côté à la borne de tension continue négative du redresseur en pont (D1/D2/D3/D4), caractérisé par le fait que la troisième résistance (R3) est connectée d'autre part aux anodes de deux diodes (D6, D7) qui sont connectées par leur cathode aux bornes extérieures des moitiés d'enroulement secondaire du transformateur (T) et à la grille du commutateur auxiliaire (S2).

2. Circuit selon la revendication 1, caractérisé par le fait qu'une diode (D5) est placée entre le piquage central et le deuxième condensateur (C2), diode dont la cathode est connectée au premier condensateur.

3. Circuit selon la revendication 1 et/ou la revendication 2, caractérisé par le fait qu'un deuxième condensateur (C1) est connecté en parallèle avec la troisième résistance.

4. Circuit selon au moins une des revendications 1 à 3, caractérisé par le fait qu'une quatrième résistance (R2) est placée entre les bornes de tension continue du redresseur en pont (D1/D2/D3/D4).
